# EUROPEAN PATENT APPLICATION

(11) **EP 4 783 236 A1**
(43) Date of publication of application: **29.07.2026**
(21) Application number: 24868333.6
(22) Date of filing: 19.09.2024
(51) Int. Cl.: H01L 23/13, H01L 23/12, H05K 1/02

(54) **CERAMIC SCRIBE SUBSTRATE, METHOD FOR MANUFACTURING CERAMIC SCRIBE SUBSTRATE, METHOD FOR MANUFACTURING CERAMIC SUBSTRATE, AND METHOD FOR MANUFACTURING CERAMIC CIRCUIT SUBSTRATE**

(30) Priority: 19.09.2023 JP 2023151624
(71) Applicant: Niterra Materials Co., Ltd., Yokohama-shi, Kanagawa 235-0032 (JP)
(72) Inventor: HOSHINO, Naoto, Yokohama-shi, Kanagawa 235-0032 (JP); MATSUMOTO, Yukihisa, Yokohama-shi, Kanagawa 235-0032 (JP)
(74) Representative: Hoffmann Eitle
(86) International application number: PCT/JP2024/033558
(87) International publication number: WO 2025/063256

(57) **Abstract**

A ceramic scribe substrate capable of providing a large number of ceramic substrates with few burrs and/or chips during division is provided. The ceramic scribe substrate includes an edge scribe line and a corner scribe line. In a vicinity of an intersection between the corner scribe line and the edge scribe line, an auxiliary scribe line extends along the edge scribe line and the intersection. A length of the auxiliary scribe line is 0.5 mm or more and 15.0 mm or less. The edge scribe line and the auxiliary scribe line are formed by dots.

## Description

### FIELD

Embodiments generally relate to a ceramic scribe substrate, a method for manufacturing a ceramic scribe substrate, a method for manufacturing a ceramic substrate, and a method for manufacturing a ceramic circuit board.

### BACKGROUND

In recent years, with the development of semiconductor elements requiring a large current, such as power electronics and next-generation power semiconductors, the demand for ceramic substrates having both heat dissipation and electrical insulation has increased year by year. In particular, as the heat generation of the element increases with miniaturization and high performance, the thickness of the ceramic substrate tends to decrease in order to efficiently dissipate heat. On the other hand, in order to reduce the manufacturing cost of the ceramic substrate, manufacturing in a larger shape has been performed. Among ceramic substrates, as a silicon nitride substrate having high strength and high toughness and also having high heat dissipation, a substrate having a size of 220 mm × 220 mm × 0.32 mm is disclosed (Patent Literature 1).

In order to efficiently manufacture a ceramic substrate, a method of manufacturing a large ceramic substrate and dividing the ceramic substrate into the size of a product is adopted. For a silicon nitride substrate having both high strength and high thermal conductivity, a division method by laser scribing is disclosed (Patent Literatures 2 and 3). According to Patent Literature 2, the occurrence of burrs and the like can be suppressed by deepening scribe holes and reducing their pitch. In addition, according to Patent Literature 3, a rectangular silicon nitride-based ceramic scribe substrate having chamfered portions at four corners of an outer peripheral portion can be divided into product shapes.

### CITATION LIST

### PATENT LITERATURE

Patent Literature 1: Japanese Patent No. 6399252
Patent Literature 2: Jpn. Pat. Appln. KOKAI Publication No. 2008-198905
Patent Literature 3: Japanese Patent No. 6990360

### SUMMARY

### TECHNICAL PROBLEM

On the other hand, in order to reduce the manufacturing cost of the ceramic substrate, it has been found that a new problem is caused by performing laser processing on the ceramic substrate that has become large and thin. For example, when an individual substrate is to be obtained from a large silicon nitride substrate by laser processing, a large force is required to break (divide) the silicon nitride substrate along a scribe line because of its high strength, and thus it is necessary to make the laser penetrate deeply in a thickness direction of the silicon nitride substrate. However, if the silicon nitride substrate is thin, the silicon nitride substrate is more likely to be divided by a force applied during conveyance, or in a processing step after formation of a laser scribe line. Conversely, if the laser is made to penetrate shallowly in the thickness direction of the silicon nitride substrate, there is a low possibility of being divided in an intermediate step. However, it is necessary to apply a large force during breaking, a work load is generated, and chips or cracks may be generated in an outer peripheral portion due to application of a large force.

In addition, a problem caused by chamfering a ceramic substrate constituting a ceramic scribe substrate has been clarified. Even if a conventional ceramic scribe substrate has a chamfered portion, a scribe line of the chamfered portion is formed in the same shape as other scribe lines. Therefore, a small chamfered portion of a thin ceramic substrate having high strength is hardly cracked as described above, and the chamfered portion may remain on the substrate without being broken, leading to a problem that yield and workability are deteriorated.

The embodiments are intended to solve such a problem, and are capable of reducing the possibility that an unbroken portion remains on the ceramic substrate upon breaking and adversely affect the ceramic substrate, and are also capable of reducing the occurrence of burrs and chips during breaking.

### SOLUTION TO PROBLEM

According to one embodiment, a ceramic scribe substrate includes an edge scribe line and a corner scribe line. In a vicinity of an intersection between the corner scribe line and the edge scribe line, an auxiliary scribe line extends along the edge scribe line and the intersection.

A method for manufacturing the ceramic scribe substrate according to the embodiment, including:
forming dots on a ceramic substrate by laser irradiation,
thereby forming the edge scribe line, the corner scribe line, and the auxiliary scribe line.

According to the embodiment, a method for manufacturing a ceramic substrate, including: applying stress to the ceramic scribe substrate according to the embodiment and dividing the ceramic scribe substrate along the scribe line, thereby manufacturing a ceramic substrate.

According to the embodiment, a method for manufacturing a ceramic circuit board, including: manufacturing a ceramic substrate by the method according to the embodiment, and
joining a metal circuit to the ceramic substrate, thereby manufacturing a ceramic circuit board.

According to the embodiment, a method for manufacturing a ceramic circuit board, including:
joining a metal circuit to the ceramic scribe substrate according to the embodiment; and
applying stress to the ceramic scribe substrate to which the metal circuit is joined, and dividing the ceramic scribe substrate along the scribe line, thereby manufacturing a ceramic circuit board.

### BRIEF DESCRIPTION OF DRAWINGS

FIG. 1 is a schematic view showing an example of a ceramic scribe substrate provided with a scribe line according to an embodiment.
FIG. 2 is a schematic view showing an example of a ceramic substrate obtained by dividing the ceramic scribe substrate according to the embodiment.
FIG. 3 is a schematic view showing an example in which an edge scribe line and a corner scribe line are provided according to the embodiment.
FIG. 4 is a schematic view showing an example in which an auxiliary scribe line is provided in the edge scribe line and the corner scribe line in FIG. 3.
FIG. 5 is a schematic view showing an example in which the corner scribe line is extended according to the embodiment.
FIG. 6 is a schematic view showing an example in which the corner scribe line is a continuous groove according to the embodiment.
FIG. 7 is a schematic view showing an example in which the corner scribe line having a curved shape is provided according to the embodiment.
FIG. 8A is an enlarged view showing a first example of a portion A in FIG. 4.
FIG. 8B is an enlarged view showing a second example of a portion A in FIG. 4.
FIG. 8C is a cross-sectional view taken along line C-C in the auxiliary scribe line of a ceramic scribe substrate shown in FIG. 8B.
FIG. 9 is a side view showing an example of a ceramic circuit board according to an embodiment.
FIG. 10 is a side view showing an example of the ceramic circuit board integrated with a resin molding according to an embodiment.
FIG. 11 is a schematic view showing an example of a dot of the scribe line of the ceramic scribe substrate shown in FIG. 1.
FIG. 12 is a cross-sectional view of a substrate portion including the scribe line shown in FIG. 11 taken along line XII-XII.
FIG. 13 is a plan view showing the vicinity of an end portion of a ceramic substrate divided from the ceramic scribe substrate shown in FIG. 11.
FIG. 14 is a cross-sectional view showing a part of a dot of the scribe line shown in FIG. 12.
FIG. 15 is a cross-sectional view showing an example of a dot obtained by reprocessing the dot shown in FIG. 14 with a laser.
FIG. 16 is a schematic view showing a ceramic scribe substrate provided with a scribe line according to Examples 1 and 9.

### DETAILED DESCRIPTION

Hereinafter, the embodiments of a ceramic scribe substrate, a ceramic substrate, a method for manufacturing a ceramic scribe substrate, a method for manufacturing a ceramic substrate, and a method for manufacturing a ceramic circuit board will be described in detail with reference to the drawings.

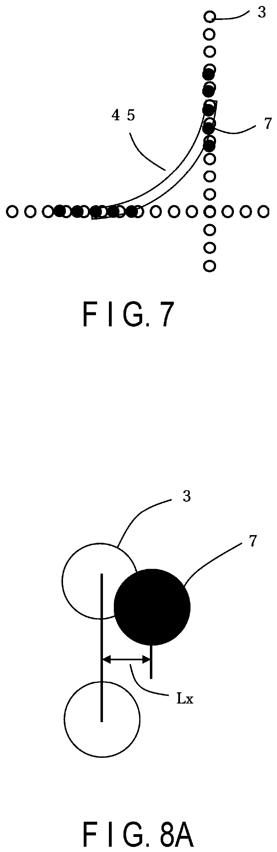

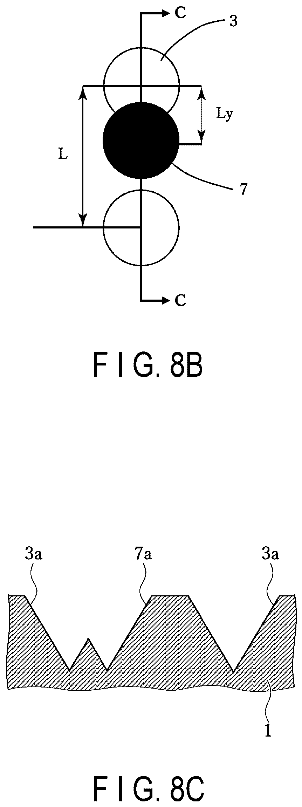

The ceramic scribe substrate according to an embodiment is a ceramic scribe substrate having an edge scribe line and a corner scribe line. In the vicinity of an intersection between the corner scribe line and the edge scribe line, an auxiliary scribe line extends along the edge scribe line and the intersection. The vicinity of the intersection between the corner scribe line and the edge scribe line means an arbitrary position including the intersection between the corner scribe line and the edge scribe line. Therefore, in the ceramic scribe substrate according to the embodiment, the auxiliary scribe line is formed along the edge scribe line at an arbitrary position including the intersection between the corner scribe line and the edge scribe line. The auxiliary scribe line may be formed at the same position as the edge scribe line, may be formed at a position shifted from the edge scribe line as shown in FIGS. 8A and 8B, or may be formed at a position not overlapping the edge scribe line. As long as the auxiliary scribe line extends along the edge scribe line and the intersection, the auxiliary scribe line may not be formed at the same position as the intersection, and may not overlap the intersection.

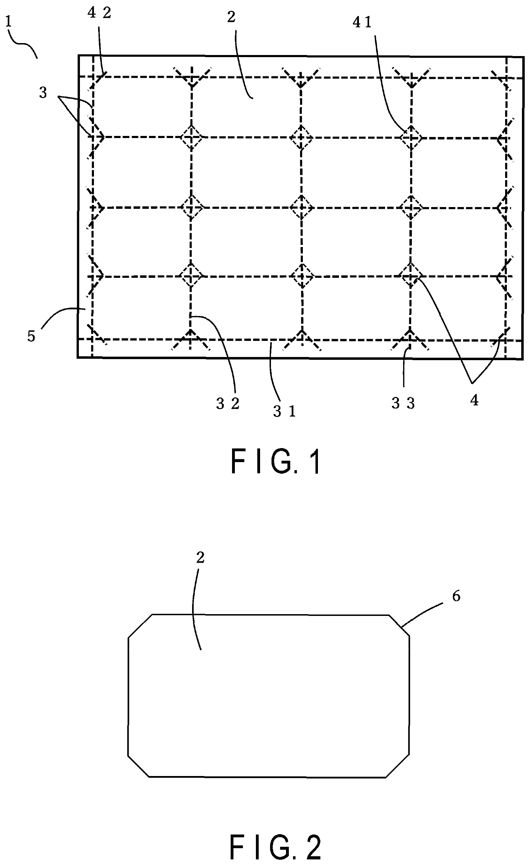

FIG. 1 is a view schematically showing an example of a ceramic scribe substrate (hereinafter, abbreviated as "scribe substrate") provided with a scribe line. A scribe substrate 1 has a total of 16 ceramic substrates 2 that serve as products (hereinafter, abbreviated as "ceramic substrates"), including four ceramic substrates in the longitudinal direction and four ceramic substrates in the lateral direction. A peripheral portion 5 that does not serve as a product is formed around the periphery of the ceramic substrate 2. A scribe line that forms the ceramic substrate 2 and the peripheral portion 5 is an edge scribe line 3. In FIG. 1, as edge scribe lines located on an outer side in contact with the peripheral portion 5 (hereinafter, abbreviated as "outer edge scribe lines"), two vertical and two horizontal outer edge scribe lines 31 are formed. In addition, as edge scribe lines located on an inner side of the outer edge scribe line 31 (hereinafter, abbreviated as "inner edge scribe lines"), three vertical and three horizontal inner edge scribe lines 32 are formed. Corner scribe lines 4 are formed around the periphery of the ceramic substrate 2 in order to form a chamfer of the ceramic substrate 2. In FIG. 1, corner scribe lines formed over the peripheral portion 5 and located on an outer side (hereinafter, abbreviated as "outer corner scribe lines") extend to the inside of the peripheral portion 5. On the other hand, terminal ends of corner scribe lines that do not overlap the peripheral portion 5 and located on an inner side (hereinafter, abbreviated as "inner corner scribe lines") are in contact with the edge scribe line 3. The embodiment is not limited to such a form, and one ceramic substrate may be processed into a product shape by a scribe line, or a large number of (more than two in the vertical and horizontal directions) ceramic substrates may be provided. In addition, it is not necessary to form scribe lines in the entire periphery of the ceramic substrate, and at least one scribe line has only to be formed. In addition, in FIG. 1, the ceramic substrates have a chamfered rectangular shape of the same size in the plan view, but may have a substantially polygonal shape. In addition, FIG. 2 is a ceramic substrate 2 obtained by breaking the scribe substrate 1, and is formed with a chamfered portion 6.

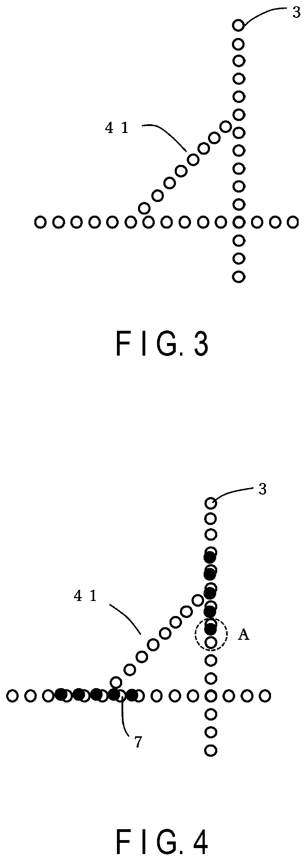

FIG. 3 is a view schematically showing the edge scribe line 3 and an inner corner scribe line 41 surrounded by the ceramic substrate 2. In FIG. 3, no inner corner scribe line 41 is formed beyond the edge scribe line 3. In FIG. 3, no auxiliary scribe line is formed, and the conventional inner corner scribe line 41 is formed. The ceramic substrate 2 is obtained by breaking the scribe substrate 1 along the edge scribe line 3 of the scribe substrate 1. Further, the chamfered portion 6 is formed by breaking the ceramic substrate 2 along the corner scribe line 4.

FIG. 4 is a view schematically showing a state in which an auxiliary scribe line 7 is formed after the edge scribe line 3 and the inner corner scribe line 41 are formed. In FIG. 4, the auxiliary scribe line 7 is represented by black circles to be distinguished from the edge scribe line 3. In the vicinity of an intersection between the inner corner scribe line 41 and the edge scribe line 3, the auxiliary scribe line 7 that intersects the intersection is formed along the edge scribe line 3. In a case where the edge scribe line 3 and the inner corner scribe line 41 are formed by dots through laser processing, processability is improved if the dot interval is widened. However, if the dot interval at the intersection between the edge scribe line 3 and the inner corner scribe line 41 is wide, a force is applied at an acute angle, so that sharp breaking cannot be performed, leading to occurrence of burrs. Therefore, by forming the auxiliary scribe line along the edge scribe line 3, the portion where the auxiliary scribe line is formed is easily broken, and burrs generated during breaking at the intersection between the edge scribe line 3 and the inner corner scribe line 41 can be suppressed. In addition, since the auxiliary scribe line 7 is formed in a portion of the edge scribe line 3, the edge scribe line 3 is prevented from being unnecessarily broken due to application of force in a subsequent step. Note that, in FIG. 4, the auxiliary scribe line 7 that intersects the intersection along the edge scribe line 3 is formed at the intersection between each end portion of both end portions of the inner corner scribe line 41 and the edge scribe line 3, but the auxiliary scribe line 7 that intersects the intersection may be formed at one intersection of both the intersections.

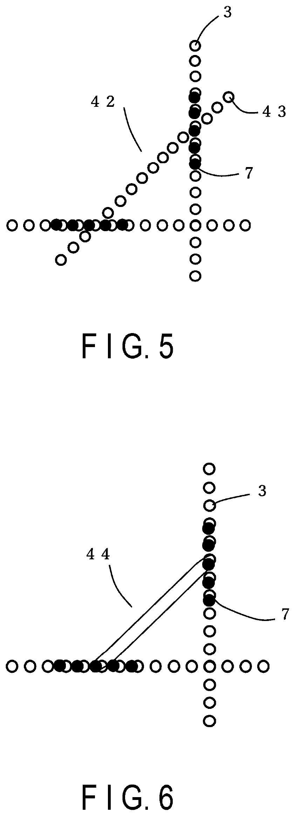

FIG. 5 is a view schematically showing a state in which an outer corner scribe line 42 that forms a chamfer is formed in the peripheral portion 5. As shown in FIG. 5, an extended portion 43 can be formed by extending the corner scribe line as long as the peripheral portion 5 is not used as a product. This is because, by providing the extended portion 43 of the outer corner scribe line 42 with respect to the small chamfered portion that is less likely to receive force during breaking, the force is easily applied and the chamfered portion is easily broken as the corner scribe line becomes longer.

It is also possible to form the inner corner scribe line 41 and the auxiliary scribe line 7 not by dots but by a continuous groove. Formation of a continuous groove can reduce the occurrence of an unbroken portion and burrs, but is inferior in cost performance. Therefore, the inner corner scribe line 41 and the auxiliary scribe line 7 are preferably composed of dots.

FIG. 6 is a schematic view in which the corner scribe line 4 is formed not by dots but by a continuous groove 44. As described above, formation of a continuous groove is disadvantageous in cost performance, but when the chamfered portion is small, dots make it difficult to apply a force to the break portion in the case of dots, and a burr defect is likely to occur. Therefore, in a case where the chamfering is, for example, 1 mm or less in C-chamfering and R-chamfering, the corner break line is preferably formed by the continuous groove 44.

The corner scribe line 4 may be straight as shown in FIGS. 3 to 6. Alternatively, it may be curved as shown in FIG. 7. The corner scribe line 45 of FIG. 7 is curved and can form an R-chamfer.

The corner scribe line 4 is preferably formed before the auxiliary scribe line 7 is provided. By forming the corner scribe line 4 first, it is possible to form the auxiliary scribe line 7 with less positional deviation, thereby making it possible to shorten the auxiliary scribe line 7. A length of each auxiliary scribe line 7 to be formed is preferably 0.5 mm or more and 15 mm or less. If the length is less than 0.5 mm, the effect obtained by providing the auxiliary scribe lines 7 may not be sufficient. On the other hand, if the length is as long as more than 15 mm, the effect obtained by providing the auxiliary scribe line will be unchanged, but the processing time will be longer and production efficiency may decrease. Therefore, the length of the auxiliary scribe line 7 is more preferably 2 mm or more and 13 mm or less, and still more preferably 4 mm or more and 11 mm or less.

FIG. 8A is an enlarged view of a first example of a portion A in FIG. 4. In FIG. 8A, a center point of a dot of the edge scribe line and a center point of a dot of the auxiliary scribe line do not overlap. In FIG. 8A, a distance to a straight line passing through a center point of the auxiliary scribe line 7, among distances in a direction perpendicular to a straight line direction formed by dots of the edge scribe line 3, is Lx. The edge scribe line 3 and the auxiliary scribe line 7 are preferably parallel, but the distance Lx in a case where the edge scribe line 3 and the auxiliary scribe line 7 are not parallel is a distance at a place where the edge scribe line 3 and the auxiliary scribe line 7 are farthest from each other. At this time, the distance Lx between the auxiliary scribe line 7 and the edge scribe line 3 is preferably provided as 100 µm or less. If the auxiliary scribe line 7 is far from the edge scribe line 3, the effect of assisting the breaking at the intersection is reduced, leading to the occurrence of a burr defect due to the auxiliary scribe line 7 being far from the edge scribe line 3. Therefore, the distance Lx is more preferably 50 µm or less, and still more preferably 25 µm or less.

In FIG. 8B, a distance between the dots of the edge scribe line 3 is L, and a distance between the dot of the auxiliary scribe line 7 and the dot of the edge scribe line 3 is Ly. At this time, the dot position of the auxiliary scribe line 7 is preferably at a position of 1/4 to 3/4 of a pitch width L of the edge scribe line 3. The fact that the dot position of the auxiliary scribe line 7 is at a position of 1/4 means that the dot of the auxiliary scribe line 7 is formed at a position shifted by 1/4 by dividing the distance between the dots of the edge scribe line 3 into four equal parts. This is because when the dot position of the auxiliary scribe line 7 is located far from the dot position of the edge scribe line, the dots of the auxiliary scribe line 7 and the edge scribe line 3 are arranged on the line, resulting in easy breaking. Therefore, the auxiliary scribe line 7 is preferably located at a position of 1/3 to 2/3 of the distance L between dots of the edge scribe line 3. Further, the auxiliary scribe line 7 is more preferably located at a position of 1/2 of the distance L between the dots of the edge scribe line 3. Being located at a position of 1/2 means that the dot position of the auxiliary scribe line 7 exists at a center portion obtained by dividing the distance between the dots of the edge scribe line 3 into two. Here, the distance L between dots is a distance between dot-shaped holes, but average values of distances between dots of one scribe line are compared. Therefore, there may be a portion that partially does not satisfy the above condition.

FIG. 8C is a cross-sectional view schematically showing a cross section obtained when the edge scribe line 3 portion provided with the auxiliary scribe line 7 in the scribe substrate shown in FIG. 8B is cut along line C-C. Each of a dot 3a of the edge scribe line 3 and a dot 7a of the auxiliary scribe line 7 is a recess having an inverted conical shape. A portion where a part of the dot 7a of the auxiliary scribe line 7 overlaps a part of the dot 3a of the edge scribe line 3 has an uneven shape in which a recess corresponding to the dot 3a and a recess corresponding to the dot 7a are connected.

Further, a dot depth of the auxiliary scribe line 7 is preferably equal to or greater than a dot depth of the edge scribe line 3. This is because a place of an intersection forming the auxiliary scribe line 7 is more likely to break than that forming the edge scribe line 3, and thus a deeper dot is more likely to cause breaking. More preferably, the dot depth of the auxiliary scribe line 7 is 1.5 times or more the dot depth of the edge scribe line 3. In this case, both the front and back surfaces of the scribe substrate 1 may be penetrated. In addition, the corner scribe line 4 may be processed to form a through groove. In addition, the auxiliary scribe line 7 may be provided at another place to facilitate division of the portion where the auxiliary scribe line 7 is provided.

In addition, the number of auxiliary scribe lines may be one or two per corner scribe line. On the other hand, since the auxiliary scribe line is formed along the portion where the edge scribe line is formed, the groove width of the laser scribe line may be wider at the portion where the auxiliary scribe line is formed than at other portions in the same edge scribe line. As a result, a microscopic step is generated when viewed from the laser-processed surface. Therefore, the auxiliary scribe line is preferably short at a portion where the ceramic substrates are in contact with each other. The portion where the ceramic substrates are in contact with each other is, for example, a portion indicated by the inner corner scribe line 41 in FIG. 1.

Further, preferably, the inner corner scribe line 41 in the scribe substrate does not have an extended portion, and the outer corner scribe line 42 has an extended portion 43. A length of the extended portion 43 is preferably 0.1 mm or more and 8 mm or less. More preferably, the length of the extended portion is 0.2 mm or more and 5 mm or less. If the length is as short as less than 0.1 mm, the corner scribe line does not reach the portion of the auxiliary scribe line, and there is a possibility that a defect occurs at the time of division. On the other hand, if the length is as long as more than 8 mm, when breaking occurs along the edge scribe line, a portion close to an edge of the corner scribe line is divided in fine pieces.

In addition, the lengths of the edge scribe lines 3 may be the same or different between the edge scribe lines existing in parallel. Preferably, two sets of outer edge scribe lines 31, i.e., four outer edge scribe lines 31, adjacent to the peripheral portion 5 are longer than the inner edge scribe lines 32 existing in parallel thereto. More preferably, the inner edge scribe line 32 is vertically in contact with the outer edge scribe line 31, and preferably has a protruding portion 33 of 0.1 mm or more and 8 mm or less to an outer peripheral side from an intersection of the outer edge scribe line 31 vertically in contact with the inner edge scribe line 32. When a length of the protruding portion 33 is shorter than the outer edge scribe line 31, the processing time can be shortened.

The laser used for processing the edge scribe line 3 and the corner scribe line 4 is preferably any of a YAG laser (fundamental wave or double wave), a fiber laser, an excimer laser, a semiconductor laser, and a CO₂ laser. A wavelength of the laser to be used is preferably 500 nm or more and 1100 nm or less. More preferably, a fiber laser or a YAG laser is used. More preferably, a fiber laser is used. Use of a fiber laser is preferable because processing can be performed with stable output and high efficiency. Furthermore, the fiber laser can process a thin and deep scribe line. Further, at the time of laser processing, it is preferable to place the scribe substrate on a table and move the table to perform laser processing.

An oscillation mode of the laser is preferably either a continuous mode or a pulse mode. In particular, when oscillation in the pulse mode is used, a pulse width is preferably in units of picoseconds or less. The pulse width in units of picoseconds or less is preferable because fine processing is easily performed.

Further, as necessary, an assist gas may be used, or dust may be collected. By collecting dust, the generated powder dust can be prevented from adhering to a laser irradiation port and covering the laser irradiation port.

The ceramic substrate 2 is preferably any one of a silicon nitride substrate, an aluminum nitride substrate, and an aluminum oxide substrate. An alumina-zirconia substrate is also exemplified as a kind of aluminum oxide substrate. The alumina-zirconia is a sintered body in which the balance is zirconium oxide with respect to 20 to 80 wt% of aluminum oxide. A three-point bending strength of the aluminum nitride substrate or the aluminum oxide substrate is about 300 to 450 MPa. A strength of the alumina-zirconia substrate is also around 550 MPa. A three-point bending strength of the silicon nitride substrate can be increased to 600 MPa or more, and further to 700 MPa or more. In addition, a thermal conductivity of the silicon nitride substrate can be increased to 50 W/m·K or more, and further to 80 W/m·K or more. In recent years, there is also a silicon nitride substrate having both high strength and high thermal conductivity.

In addition, the ceramic substrate is preferably a substrate to be divided into a plurality of parts, and in a case where the ceramic substrate is divided into a plurality of parts, a size of the ceramic substrate is preferably so as to achieve a rectangular shape having a size of a short side of 10 cm or more and a long side of 20 cm or more. As described above, when the ceramic substrate to be processed is large, a larger number of ceramic substrates can be obtained from one scribe substrate. Therefore, ceramic substrates divided efficiently can be obtained.

In addition, a thickness of the ceramic substrate is preferably 0.1 mm or more and 2 mm or less. If the thickness is as large as more than 2 mm, processing may take time. On the other hand, when the thickness is as thin as less than 0.1 mm, there is a possibility that sufficient strength cannot be maintained. A more preferable thickness of the ceramic substrate is 0.2 mm or more and 1 mm or less. A thickness of the ceramic substrate of 0.2 mm or more and 1 mm or less is preferable because processing can be performed with high efficiency while maintaining sufficient strength.

Furthermore, the obtained scribe substrate preferably involves a step of cleaning its surface by honing, blasting, or the like in a subsequent step.

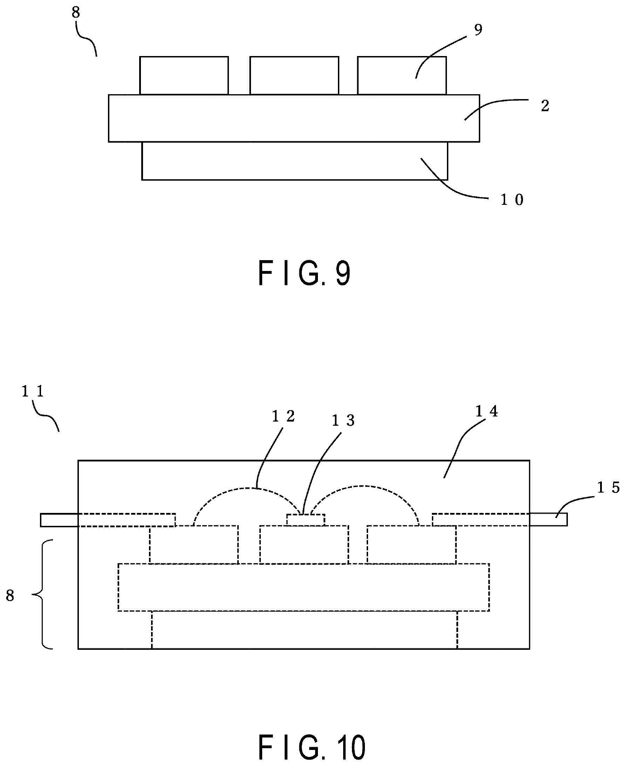

It is possible to form a ceramic circuit board by joining a metal circuit such as a metal plate to the divided ceramic substrate 2 by laser processing. FIG. 9 shows an example of a ceramic circuit board 8 according to an embodiment. In FIG. 9, reference numeral 8 denotes a ceramic circuit board, reference numeral 2 denotes a ceramic substrate, reference numeral 9 denotes a metal circuit, and reference numeral 10 denotes a metal heat sink.

Examples of the metal plate used in the metal circuit 9 include Cu (copper), a copper-based alloy, and Al (aluminum). The ceramic substrate 2 and the metal circuit 9 are preferably joined via a joining layer (not shown in the figure). Also when the metal heat sink is joined, it is preferable to join the metal heat sink via the joining layer. In addition, the joining layer is preferably provided between the ceramic substrate 2 and the metal circuit 9 with an active metal brazing material containing an active metal such as Ti (titanium). Examples of the active metal include Zr (zirconium) in addition to Ti. Examples of the active metal brazing material include a mixture containing either one of Ag (silver) or Cu as a main component in addition to Ti. In addition, an amount of Ti is 0.1 wt% or more and 10 wt% or less, an amount of Cu is 10 wt% or more and 60 wt% or less, and Ag is the balance. In addition, if necessary, 1 wt% or more and 15 wt% or less of one or more selected from In (indium), Sn (tin), Al, Si (silicon), C (carbon), and Mg (magnesium) may be added. In the active metal joining method using an active metal brazing material, an active metal brazing material paste is applied to a surface of the ceramic substrate 2, and the metal circuit 9 is disposed thereon. This is joined by heating at 600°C or higher and 900°C or lower. According to the active metal joining method, joining strength between the ceramic substrate 2 and the metal circuit 9 such as a copper circuit board can be 16 kN/m or more.

In addition, a metal thin film containing one selected from Ni (nickel), Ag (silver), and Au (gold) as a main component may be provided on a surface of the metal circuit 9. Examples of these metal thin films include plating films and sputtered films. By providing the metal thin film, corrosion resistance and solder wettability can be improved.

In addition, in the scribe substrate, it is preferable to join a conductor portion before dividing each ceramic substrate. At this time, the conductor portion to be joined is preferably a copper member or aluminum member having excellent thermal conductivity. The copper member or aluminum member includes copper, a copper alloy, aluminum, or an aluminum alloy. When the conductor is joined, the conductor portion having a predetermined shape may be joined in advance. When a step of providing the conductor portion is performed by joining the metal plate, the metal plate to be joined preferably undergoes a step such as etching or chemical polishing in a subsequent step.

Such a ceramic circuit board 8 is suitable for a semiconductor module characterized in that a semiconductor element is mounted on the metal circuit 9 via a joining layer.

FIG. 10 shows an example of a semiconductor module (semiconductor device) according to an embodiment. In FIG. 10, reference numeral 8 denotes a ceramic circuit board, reference numeral 11 denotes a semiconductor module, reference numeral 12 denotes wire bonding, reference numeral 13 denotes a semiconductor element, reference numeral 14 denotes a resin molding, and reference numeral 15 denotes a lead frame.

In FIG. 10, the semiconductor element 13 is joined onto the metal circuit 9 of the ceramic circuit board 8 via a joining layer (not shown). Similarly, the lead frame 15 is joined via a joining layer (not shown). Adjacent metal circuits 9 are electrically connected to each other by the wire bonding 12. In FIG. 10, the wire bonding 12 and the metal circuit 9 are joined together in addition to the semiconductor element 13. The ceramic circuit board 8 to which the wire bonding 12 is connected is integrated by the resin molding 14 to form the semiconductor module 11. The semiconductor module 11 is not limited to such a structure. For example, either one of the wire bonding 12 or the lead frame 15 may be used. A plurality of the semiconductor elements 13, a plurality of the wire bondings 12, and a plurality of the lead frames 15 may be provided in the metal circuit 9.

Examples of the joining layer for joining the semiconductor element 13 and the lead frame 15 include a solder and a brazing material. The solder is preferably a lead-free solder. The solder has a melting point of 450°C or lower. The brazing material has a melting point higher than 450°C. A brazing material having a melting point of 500°C or higher is referred to as high-temperature brazing material. Examples of the high-temperature brazing material include those containing Ag as a main component.

While the semiconductor element 13 is being miniaturized, an amount of heat generated from a chip is continuously increasing. Therefore, it is important to improve heat dissipation in the ceramic circuit board 8 on which the semiconductor element 13 is mounted. In addition, in order to improve the performance of the semiconductor module 11, a plurality of semiconductor elements 13 are mounted on the ceramic circuit board 8. Even if only one semiconductor element 13 exceeds an intrinsic temperature of the element, the resistance changes to a negative temperature coefficient. As a result, a phenomenon occurs in which thermal runaway in which electric power intensively flows occurs, leading to destruction. Therefore, it is effective to improve the heat dissipation. In addition, the semiconductor module 11 can be used in a PCU, an IGBT, and an IPM module used in an inverter of an automotive vehicle (including an electric vehicle), a railway vehicle, an industrial machine, an air conditioner, or the like. Automotive vehicles are becoming electric vehicles. The improvement of the reliability of the semiconductor module 11 directly leads to the safety of the automotive vehicles. The same applies to railway, industrial equipment, and the like.

Next, a laser scribing method of a silicon nitride substrate in the ceramic scribe substrate 1 according to the embodiment will be described. As long as the laser scribing of the silicon nitride substrate has the above-described configuration, a method for manufacturing the silicon nitride substrate is not particularly limited, but examples of a method for obtaining the silicon nitride substrate with high yield include the following methods.

First, a silicon nitride substrate is prepared. In particular, in consideration of the heat dissipation of the entire ceramic circuit board 8 generated from the silicon nitride substrate, the silicon nitride substrate preferably has a thermal conductivity of 50 W/m·K or more and a three-point bending strength of 600 MPa or more.

When electrical connection between the metal circuit 9 and the metal heat sink 10 is performed, a silicon nitride substrate having a through hole is prepared. When a through hole is provided in the silicon nitride substrate, the through hole may be provided in advance at the stage of a molded body. Further, a step of providing a through hole in a silicon nitride sintered body may be performed. The step of providing a through hole is performed by laser processing, cutting processing, or the like similar to laser scribing. Cutting processing is performed by drilling with a drill or the like.

The silicon nitride substrate is set on a precision processing table of a laser processing machine. The silicon nitride substrate is irradiated with a laser to form the edge scribe line 3, the corner scribe line 4, and the auxiliary scribe line 7. At this time, dots or a continuous groove having a predetermined size are formed under conditions of the laser processing machine.

Next, one or more ceramic substrates 2 are manufactured by applying stress to the silicon nitride substrate as the ceramic scribe substrate 1 to divide the ceramic scribe substrate 1 along the scribe line 3.

Next, the metal circuit 9 is joined to the silicon nitride substrate as the ceramic substrate 2. The silicon nitride substrate and the metal circuit 9 are preferably joined by an active metal joining method. In the active metal joining method, an active metal brazing material mixed with an active metal such as Ti is used. Examples of the active metal brazing material include a mixture of Ti, Ag, and Cu, and for example, an amount of Ti is 0.1 wt% or more and 10 wt% or less, an amount of Cu is 10 wt% or more and 60 wt% or less, and Ag is the balance. In addition, if necessary, 1 wt% or more and 15 wt% or less of one or more selected from In, Sn, Al, Si, C, and Mg may be added.

The active metal brazing material is formed into a paste. The paste is a mixture of a brazing material component and an organic substance, but the brazing material component needs to be uniformly mixed. This is because if the brazing material component is ununiformly distributed, the brazing is not stabilized and causes a joining defect.

The active metal brazing material paste is applied to the ceramic substrate 2. A copper plate is disposed thereon. Next, a step of heating this at 600°C or higher and 900°C or lower for joining is performed. A heating step is performed in vacuum or in a non-oxidizing atmosphere as necessary. In the case of performing in vacuum, the pressure is preferably 1 × 10⁻² Pa or less. Examples of the non-oxidizing atmosphere include a nitrogen atmosphere and an argon atmosphere. The vacuum or the non-oxidizing atmosphere can suppress oxidation of the joining layer. This improves the joining strength.

The metal circuit 9 to be joined may be either a metal circuit processed into a pattern shape in advance for circuit formation or a single plate not subjected to pattern processing. In addition, when a single plate is used, etching processing is performed after joining to form a pattern shape. Through this step, a silicon nitride metal circuit board as the ceramic circuit board 8 can be manufactured.

Next, a step of joining the semiconductor element 13 and the like is performed. A joining layer is provided at a position where the semiconductor element 13 is joined. The joining layer is preferably a solder or a brazing material. The joining layer is provided, and the semiconductor element 13 is provided thereon. In addition, the lead frame 15 is joined via the joining layer as necessary. In addition, the wire bonding 12 is provided as necessary. In addition, a required number of semiconductor elements 13, lead frames 15, and wire bondings 12 are provided. The semiconductor element 13, the lead frame 15, and the silicon nitride circuit board subjected to the wire bonding 12 are integrated by a resin molding 16 to hermetically seal the inside.

In the above description, it has been described that the ceramic circuit board 8 is manufactured by joining the metal circuit 9 and the like to the divided ceramic substrate 2 from the ceramic scribe substrate 1, but the present invention is not limited thereto. For example, the ceramic circuit board 8 may be manufactured by joining the metal circuit 9 and the like to the ceramic substrate 2 before being divided in the ceramic scribe substrate, and applying stress to the ceramic scribe substrate 1 to which the metal circuit 9 and the like are joined to divide the ceramic scribe substrate 1 along a scribe line. That is, the order of the dividing step of the ceramic scribe substrate 1 and the joining step of the metal circuit 9 and the like is not limited. In addition, it is also possible to join a metal plate such as a copper plate to the ceramic substrate 2 before being divided in the ceramic scribe substrate, and form the metal circuit 9 by processing such as etching. The ceramic scribe substrate 1 to which the metal circuit 9 and the like thus obtained are joined may be divided along a scribe line by applying stress to the ceramic scribe substrate 1.

A laser scribing method of an aluminum nitride substrate in the ceramic scribe substrate 1 according to the embodiment will be described. First, an aluminum nitride substrate is prepared. In particular, in consideration of the heat dissipation of the entire ceramic circuit board, the aluminum nitride substrate preferably has a thermal conductivity of 170 W/m·K or more and a three-point bending strength of 350 MPa or more. As long as the laser scribing of the aluminum nitride substrate has the above-described configuration, a method for manufacturing the aluminum nitride substrate is not particularly limited, but as a method for obtaining the aluminum nitride substrate with high yield, the same manufacturing process as that of the silicon nitride substrate and the silicon nitride circuit board described above is performed.

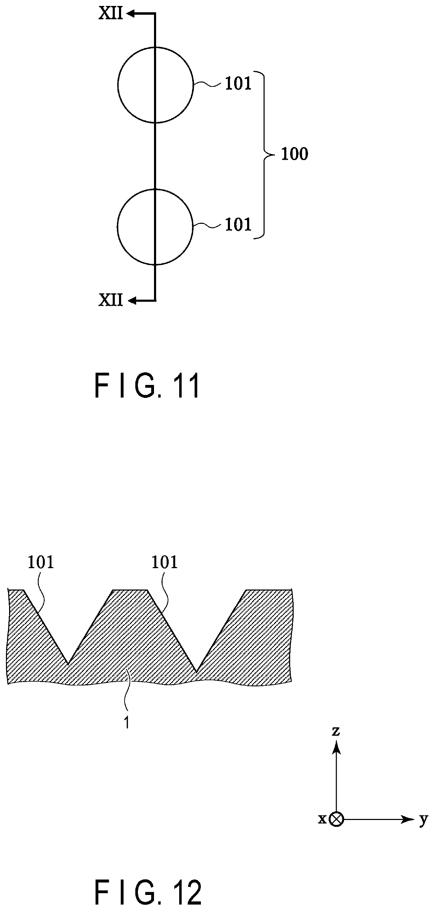

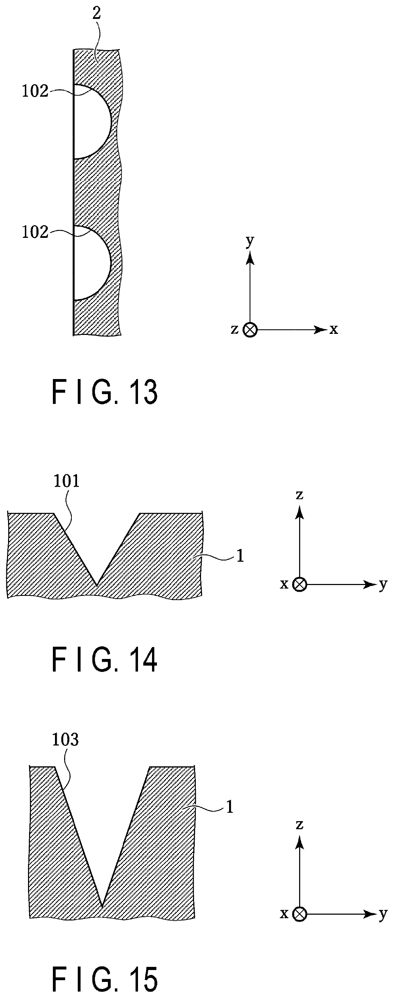

The dot shape of the scribe line provided on the ceramic scribe substrate according to the embodiment will be described with reference to FIGS. 11 to 15. FIG. 11 shows an example of dots of the scribe line shown in FIG. 1 including the edge scribe line 3 and the auxiliary scribe line 7. FIG. 12 shows a cross-sectional view of a substrate portion including the scribe line shown in FIG. 11 taken along line XII-XII. FIG. 13 is an enlarged plan view of an end portion of the ceramic substrate 2 divided along a scribe line from the ceramic scribe substrate 1. FIG. 14 is a cross-sectional view showing a part of the dot shown in FIG. 12. FIG. 15 is a cross-sectional view showing an example in which the dot shown in FIG. 14 is reprocessed with a laser. In each figure, it is assumed that a thickness direction of the ceramic scribe substrate 1 or the ceramic substrate 2 is parallel to the z-axis direction. Further, it is assumed that a principal surface of the ceramic scribe substrate 1 or the ceramic substrate 2 is parallel to the xy-plane.

As shown in FIG. 11, dots 101 are provided at intervals in the ceramic scribe substrate 1 to form a scribe line 100. The scribe line 100 may be any of the scribe lines shown in FIG. 1 including the edge scribe line 3 and the auxiliary scribe line 7. As shown in FIG. 12, each dot 101 is a recess having an inverted conical shape. The shape of the recess of the dot 101 is not limited to the inverted conical shape, and can be, for example, an inverted pyramid shape, a cylindrical shape, a prismatic shape, or a shape in which a bottom portion of each shape described above has a curved surface (for example, U-shaped or hemispherical).

When the ceramic scribe substrate 1 having the scribe line 100 shown in FIGS. 11 and 12 is divided along the scribe lines 100, one or a plurality of ceramic substrates 2 is obtained. At this time, the dot 101 is divided into two along the z-axis direction. As a result, as shown in FIG. 13, the ceramic substrate 2 has unevennesses in a part or the whole of an end portion of the principal surface. For example, a recess 102 has a substantially semicircular shape when viewed from one principal surface of the ceramic substrate 2, and has an area that decreases along a thickness direction z.

When the scribe line 100 is formed by dots through laser processing at the ceramic scribe substrate 1, for example, the dots 101 as shown in FIG. 14 are formed. When the laser processing is performed again at a position where the dot 101 is formed, the depth of the dot 101 can be increased. An example thereof is shown in FIG. 15. A dot 103 has the same inverted conical shape as the dot 101, and its depth is deeper than that of the dot 101. The size, depth, shape, and the like of the dots constituting the scribe line can vary depending on the performance of the device used for laser processing, laser processing conditions, and the type of ceramic substrate.

### (Examples 1 to 13 and Comparative Examples 1 to 5)

As shown in Table 1, 100 ceramic scribe substrates (aggregate substrates) of 140 mm × 270 mm (14 cm × 27 cm) and 110 mm × 220 mm (11 cm × 22 cm) were prepared. The type of ceramic substrate is a silicon nitride substrate, an aluminum nitride substrate, an aluminum oxide (alumina) substrate, or an alumina-zirconia substrate. The silicon nitride substrate has a thermal conductivity of 90 W/m·K and a three-point bending strength of 650 MPa. The aluminum nitride substrate has a thermal conductivity of 170 W/m·K and a three-point bending strength of 350 MPa. The aluminum oxide substrate has a thermal conductivity of 25 W/m·K and a three-point bending strength of 400 MPa. The alumina-zirconia substrate has a thermal conductivity of 25 W/m·K and a three-point bending strength of 650 MPa. As shown in FIG. 1, edge scribe lines were formed so as to obtain four ceramic substrates in the vertical direction and four ceramic substrates in the horizontal direction at a peripheral portion of 10 mm. When the size of the ceramic scribe substrate (aggregate substrate) was 140 mm × 270 mm (14 cm × 27 cm), the size of each ceramic substrate was 30 mm × 62.5 mm. When the size of the ceramic scribe substrate (aggregate substrate) was 110 mm × 220 mm (11 cm × 22 cm), the size of each ceramic substrate was 22.5 mm × 5 mm. Next, a corner scribe line was applied to the ceramic substrate. Positional relationships among the intersections between the corner scribe lines and the edge scribe lines were all designed to be the same. In Table 1, the shape of the corner scribe line is described as straight line in the case of a straight corner scribe line as shown in FIG. 4, and is described as curve in the case of a curved corner scribe line as shown in FIG. 7. In addition, an auxiliary scribe line was provided in Examples 1 to 13, and no auxiliary scribe line was provided in Comparative Examples 1 to 5.

**[Table 1]**

| | Substrate type | scribe substrate (aggregate substrate) Size (mm) | Scribe substrate (aggregate substrate) Thickness (mm) | Corner scribe line shape | Auxiliary scribe line length (mm) |
|---|---|---|---|---|---|
| Example 1 | Silicon nitride | 140 × 270 | 0.3 | Straight line | 7.0 |
| Example 2 | Silicon nitride | 140 × 270 | 0.3 | Straight line | 15.0 |
| Example 3 | Silicon nitride | 140 × 270 | 0.3 | Straight line | 0.5 |
| Example 4 | Silicon nitride | 140 × 270 | 0.3 | Curve | 7.0 |
| Example 5 | Silicon nitride | 140 × 270 | 0.2 | Straight line | 7.0 |
| Example 6 | Silicon nitride | 110 × 220 | 0.3 | Straight line | 7.0 |
| Example 7 | Silicon nitride | 110 × 220 | 0.6 | Curve | 7.0 |
| Example 8 | AlN | 140 × 270 | 0.6 | Straight line | 2.0 |
| Example 9 | AlN | 110 × 220 | 0.7 | Straight line | 14.0 |
| Example 10 | Alumina | 140 × 270 | 0.6 | Straight line | 4.0 |
| Example 11 | Alumina | 110 × 220 | 0.4 | Straight line | 12.0 |
| Example 12 | Alumina-zirconia | 140 × 270 | 1.0 | Straight line | 4.0 |
| Example 13 | Alumina-zirconia | 110 × 220 | 0.8 | Curve | 12.0 |

| | **Substrate type** | **Scribe substrate (aggregate substrate) Size (mm)** | **Scribe substrate (aggregate substrate) Thickness (mm)** | **Corner scribe line shape** | **Auxiliary scribe line length (mm)** |
|---|---|---|---|---|---|
| **Comparative Example 1** | Silicon nitride | 140 × 270 | 0.3 | Straight line | 0.0 |
| **Comparative Example 2** | Silicon nitride | 110 × 220 | 0.3 | Straight line | 0.0 |
| **Comparative Example 3** | AlN | 110 × 220 | 0.3 | Straight line | 0.0 |
| **Comparative Example 4** | Alumina | 110 × 220 | 0.3 | Straight line | 0.0 |
| **Comparative Example 5** | Alumina-zirconia | 110 × 220 | 0.3 | Straight line | 0.0 |

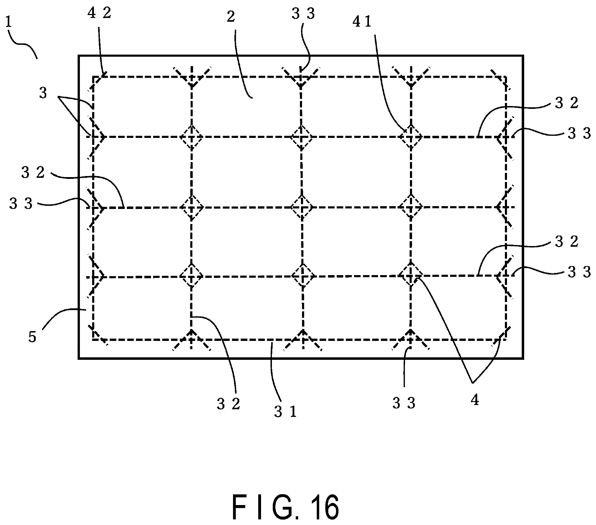

In Examples 2 to 8 and Examples 10 to 12, as shown in FIG. 1, the edge scribe lines 21 at edge portions were provided with a lenght up to edges, and a protruding portion 33 was set in which other edge scribe lines 32 portions from intersections with the edge scribes 31 at edge portions to the outer peripheral side by a lenght of 1mm or more and 7 mm or less. Furthermore, in Examples 1 and 9, an auxiliary scribe line was provided, and a protruding portion 33 was set in which, as shown in FIG. 16, only the edge scribe lines 32 protruded from intersections to the outer peripheral side by a length of 1 mm or more and 7 mm or less. In Example 13, an auxiliary scribe line was provided, and a protruding portion 43 was set in which, as shown in FIG. 5, the corner scribe line protruded from an intersection with the edge scribe line to the outer peripheral side by 1 mm or more and 7 mm or less.

On the other hand, in Comparative Example 1, all the lengths of the edge scribe lines 31 and 32 were applied so as to reach from the edge to the edge, and the corner scribe lines 41 and 42 were similarly applied so as to reach from the edge to the edge, and no auxiliary scribe line was provided. In Comparative Example 2, no auxiliary scribe line was provided, and the corner scribe line 42 was provided so as to have a length 43 slightly protruding to the outer periphery from an intersection with the edge scribe line.

Each scribe line was formed by a fiber laser. The dots constituting the scribe line had an inverted conical shape having a diameter of 0.1 mm and a depth of 0.1 mm. The size and shape of the dot are appropriately adjusted according to the performance of the device used for laser processing, the laser processing conditions, and the type of ceramic substrate, and are not limited to the sizes and shapes of the Examples. The scribe substrates of Examples and Comparative Examples were divided by a breaking device. A corner scribe line defect rate was defined as a rate of corner portions which could not be broken upon breaking by the device and remained. An edge scribe line defect rate was defined as a rate of peripheral portions which could not be broken upon breaking by the device and remained. In addition, a burr/chip defect rate was defined as a rate of ceramic substrates with burrs and/or chips when portions with a corner scribe line defect and an edge scribe line defect were broken by a jig tool, and all the divided ceramic substrates were observed. The respective defect rates are shown in Table 2.

**[Table 2]**

| | Corner scribe line defect rate (%) | Edge scribe line defect rate (%) | Burr/chip defect rate (%) |
|---|---|---|---|
| Example 1 | 3 | 4 | 2 |
| Example 2 | 2 | 2 | 1 |
| Example 3 | 5 | 8 | 4 |
| Example 4 | 6 | 8 | 3 |
| Example 5 | 4 | 6 | 0 |
| Example 6 | 3 | 3 | 1 |
| Example 7 | 4 | 5 | 2 |
| Example 8 | 7 | 5 | 3 |
| Example 9 | 5 | 4 | 1 |
| Example 10 | 9 | 7 | 1 |
| Example 11 | 5 | 4 | 2 |
| Example 12 | 7 | 8 | 3 |
| Example 13 | 4 | 5 | 1 |
| Comparative Example 1 | 14 | 19 | 10 |
| Comparative Example 2 | 12 | 11 | 9 |
| Comparative Example 3 | 17 | 15 | 16 |
| Comparative Example 4 | 19 | 17 | 20 |
| Comparative Example 5 | 11 | 13 | 15 |

In the Examples 1 to 13, all of the corner scribe line defect rate, the edge scribe line defect rate, and the burr/chip defect rate were low. This is because, by providing the auxiliary scribe line, it was possible to reduce unbroken portions of edge scribe lines and corner scribe lines while suppressing the occurrence of burrs and/or chips.

On the other hand, in Comparative Examples 1 to 5, all of the corner scribe line defect rate, the edge scribe line defect rate, and the burr/chip defect rate were high. In addition, burrs and/or chips were frequently observed at an intersection portion between the edge scribe line and the corner scribe line. This is because, in the scribe lines set in the present Examples and Comparative Examples, since there is no auxiliary scribe line, a portion that is hardly cracked remains at an intersection portion between the corner scribe line and the edge scribe line.

From the above results, it has been found that it is possible to efficiently obtain a ceramic scribe substrate which can provide a large number of ceramic substrates with few burrs and/or chips during division by providing an auxiliary scribe line in the vicinity of an intersection between the edge scribe line and the corner scribe line.

Some embodiments of the present invention have been illustrated above, but these embodiments have been presented as examples, and are not intended to limit the scope of the invention. These novel embodiments can be implemented in various other forms, and various omissions, substitutions, changes, and the like can be made without departing from the gist of the invention. These embodiments and modified examples thereof are included in the scope and gist of the invention and are also included in the invention described in the claims and the equivalent scope thereof. In addition, the above-described embodiments can be implemented in combination with each other.

### REFERENCE SIGNS LIST

- 1: Ceramic scribe substrate
- 2: Ceramic substrate
- 3: Edge scribe line
- 31: Outer edge scribe line
- 32: Inner edge scribe line
- 33: Protruding portion
- 4: Corner scribe line
- 41: Inner corner scribe line
- 42: Outer corner scribe line
- 43: Extended portion
- 44: Continuous groove
- 5: Peripheral portion
- 6: Chamfered portion
- 7: Auxiliary scribe line
- 8: Ceramic circuit board
- 9: Metal circuit
- 10: Metal heat sink
- 11: Semiconductor module
- 12: Wire bonding
- 13: Semiconductor element
- 14: Resin molding
- 15: Lead frame

## Claims

1. A ceramic scribe substrate comprising an edge scribe line and a corner scribe line, wherein
in a vicinity of an intersection between the corner scribe line and the edge scribe line,
an auxiliary scribe line extends along the edge scribe line and the intersection.

2. The ceramic scribe substrate according to claim 1, wherein a length of the auxiliary scribe line is 0.5 mm or more and 15.0 mm or less.

3. The ceramic scribe substrate according to claim 1 or 2, wherein the edge scribe line and the auxiliary scribe line are formed by dots.

4. The ceramic scribe substrate according to claim 3, wherein a center point of the dot of the edge scribe line and a center point of the dot of the auxiliary scribe line do not overlap.

5. The ceramic scribe substrate according to claim 1 or 2, wherein the ceramic scribe substrate is a silicon nitride substrate, an aluminum nitride substrate, or aluminum oxide substrate.

6. A method for manufacturing the ceramic scribe substrate according to claim 1 or 2, comprising:
forming dots on a ceramic substrate by laser irradiation,
thereby forming the edge scribe line, the corner scribe line, and the auxiliary scribe line.

7. A method for manufacturing a ceramic substrate, comprising: applying stress to the ceramic scribe substrate according to claim 1 or 2 and dividing the ceramic scribe substrate along the scribe line, thereby manufacturing a ceramic substrate.

8. A method for manufacturing a ceramic circuit board, comprising: manufacturing a ceramic substrate by the method according to claim 7, and
joining a metal circuit to the ceramic substrate, thereby manufacturing a ceramic circuit board.

9. A method for manufacturing a ceramic circuit board, comprising:
joining a metal circuit to the ceramic scribe substrate according to claim 1 or 2; and
applying stress to the ceramic scribe substrate to which the metal circuit is joined, and dividing the ceramic scribe substrate along the scribe line, thereby manufacturing a ceramic circuit board.
